# FASCICULE DE BREVET EUROPEEN

(11) **EP 2 637 071 B1**
(45) Date de publication et mention de la délivrance du brevet: **27.06.2018**
(21) Numéro de dépôt: 13305160.7
(22) Date de dépôt: 11.02.2013
(51) Int. Cl.: G06Q 10/06, G06Q 10/00, G05B 23/02

(54) **Procédé et dispositif de maintenance d'une installation électrique**
Wartungsverfahren und -vorrichtung einer elektrischen Anlage
Method and device for maintenance of an electric installation

(30) Priorité: 05.03.2012 FR 1200654
(43) Date de publication de la demande: 11.09.2013
(73) Titulaire: Schneider Electric Industries SAS, 92500 Rueil-Malmaison (FR)
(72) Inventeur: Houdray, Marc, 38050 GRENOBLE Cedex 09 (FR); Hypolite, Jean-Marie, 38050 GRENOBLE Cedex 09 (FR); Guillot, Matthieu, 38050 GRENOBLE Cedex 09 (FR); Vollet, Caroline, 38050 GRENOBLE Cedex 09 (FR); Baudouin, Jean-Luc, 38050 GRENOBLE Cedex 09 (FR)
(74) Mandataire: Tripodi, Paul

(56) Documents cités:
- EP-A1- 1 217 486
- EP-A2- 1 117 022
- WO-A1-96/20439
- DE-A1- 19 707 065
- US-A- 5 032 978
- US-A- 5 132 920

## Description

### DOMAINE TECHNIQUE

L'invention concerne un procédé de maintenance d'une installation électrique comportant au moins un appareil électrique.

L'invention concerne un dispositif de maintenance d'une installation électrique comportant au moins un appareil électrique, des moyens de traitement, et des moyens de communication destinés à être connectés audit moins un appareil électrique.

L'invention concerne aussi une installation électrique comportant la maintenance d'au moins un appareil électrique comportant des moyens de traitement et des moyens de communication destinés à être connectés à un appareil électrique.

### ETAT DE LA TECHNIQUE

Il est connu dans les procédés et les dispositifs de maintenance de remonter des informations de fonctionnement vers des superviseurs pour afficher des valeurs de courants ou de puissance en temps réel ou des causes de déclenchement d'appareils électriques tels que des disjoncteurs. Il est également connu d'entrer dans un système informatique un schéma de câblage d'une installation électrique et d'afficher un tel schéma avec des états ouverts ou fermés. Certains appareils électriques comportent des moyens d'ouverture et/ou fermeture télécommandés ou automatisés.

En cas de panne dans une installation, ces données permettent de localiser un défaut avec plus ou moins de pertinence. Cette localisation est basée essentiellement sur l'état des appareils et ne permet pas de déduire de manière suffisamment précise les causes du défaut. De plus, la remise en route de l'installation nécessite fréquemment une intervention locale pour vérifier la présence ou la disparition du défaut. Cette situation a pour conséquence une indisponibilité de l'installation prolongée même pour des pannes de faible niveau critique.

Les documents WO 96/20439, DE 197 07 065 et US 5 032 978 décrivent des procédés et des dispositifs de maintenance d'une installation électrique.

### EXPOSE DE L'INVENTION

L'invention a pour but un procédé et un dispositif de contrôle de maintenance permettant de diminuer la durée d'indisponibilité d'une installation, et une installation mettant en oeuvre ce procédé. L'invention comporte un procédé de maintenance d'une installation électrique selon la revendication 1. Avantageusement, le procédé de maintenance comporte :
- La détection d'un manque de tension dans une partie d'une installation électrique,
- la détermination de l'origine dudit manque de tension de tension en fonction d'événements enregistrés dans l'historique d'évènements.

Avantageusement, le procédé de maintenance comporte :
- la détection de courts-circuits électriques dans une ligne électrique,
- le blocage de la fermeture d'un appareil électrique ou de l'alimentation de ladite ligne électrique tant qu'un court-circuit est détecté,
- la signalisation et/ou la communication dudit blocage d'alimentation de ladite ligne. Dans le procédé de maintenance, ladite gestion de la remise en fonctionnement comporte :
- la signalisation d'évènements,
- l'acquittement d'événements ayant un niveau de criticité élevé,
- l'autorisation d'alimentation d'une ligne électrique après l'acquittement d'événements ayant un niveau de criticité élevé.

Avantageusement, le procédé de maintenance comporte :
- la détection des causes d'ouverture d'un appareil électrique de coupure en fonction de la communication de son état, de commandes locales ou distantes, de conditions de fonctionnement, et/ou d'un calcul de vieillissement,
- le blocage de la re-fermeture manuelle ou automatique dudit appareil en défaut,
- la signalisation de causes critiques de défaut de l'installation, et
- l'acquittement d'évènement signalant au moins un défaut de l'appareil.

Avantageusement, le procédé de maintenance comporte la sélection de défaillances ayant pour origine des défauts électriques et de défaillances n'ayant pas origine des défauts électrique.

De préférence, le procédé de maintenance comprend l'évaluation (135, 126) d'un niveau de criticité par un arbre de décision comprenant :
- le contrôle des causes de déclenchement d'un appareil électriques
- le contrôle des commandes externes,
- le contrôle de l'historique des alertes,
- le contrôle de sélectivité, et/ou
- le contrôle de données de vieillissement.

Avantageusement, le procédé de maintenance comporte la commande à distance de la fermeture d'appareil électrique ou d'alimentation de ligne électrique.

Selon l'invention, dans un dispositif de maintenance d'une installation électrique comportant au moins un appareil électrique, des moyens de traitement, et des moyens de communication destinés à être connectés à audit moins un appareil électrique les moyens de traitement comportent des moyens mettant en oeuvre un procédé tel que défini ci-dessus.

De préférence, lesdits moyens de traitement comportent :
- des moyens de stockage de données représentatives d'une installation électrique à contrôler,
- des moyens de stockage de données représentatives de réglages et de paramètres d'appareils électriques,
- des moyens de stockage d'informations datées représentatives d'événements arrivant dans ladite installation électrique à contrôler de manière à constituer un historique d'évènements, et
- des moyens de communication.

Avantageusement, le dispositif de maintenance comporte au moins un détecteur de courts-circuits connecté à au moins une ligne de l'installation électrique à contrôler pour fournir aux moyens de traitement des signaux représentatif de la présence d'un court-circuit.

De préférence, le dispositif de maintenance comporte au moins un détecteur de fuite de courant ou un contrôleur d'isolement disposé ou connecté à au moins une ligne de l'installation électrique à contrôler pour fournir au moyens de traitement des signaux représentatifs d'une fuite de courant à la terre ou d'un défaut d'isolement.

Avantageusement, le dispositif de maintenance comporte des moyens de réception de commande à distance d'au moins un appareil électrique.

Dans une installation électrique selon l'invention comportant la maintenance d'au moins un appareil électrique comportant des moyens de traitement et des moyens de communication destinés à être connectés à un appareil électrique, les moyens de traitement comportent des moyens mettant en oeuvre un procédé tel que défini ci-dessus. Avantageusement, l'installation électrique comportant des appareils électriques, comporte au moins un dispositif tel que défini ci-dessus connecté par des moyens de communication auxdits appareils électriques pour recevoir des données représentatives d'évènements.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma d'un dispositif de maintenance d'une installation électrique selon un mode de réalisation de l'invention ;
- la figure 2 représente un schéma d'une installation électrique comportant un contrôle de maintenance selon un mode de réalisation l'invention ;
- les figures 3 à 5 représentent des installations selon des variantes de modes de réalisation de l'invention ;
- la figure 6 représente un schéma d'un d'appareil électrique destiné à être utilisé avec un dispositif de maintenance d'une installation électrique selon un mode de réalisation de l'invention ;
- la figure 7 représente un schéma de présentation des données d'appareils électriques montrant des informations pour la gestion de la maintenance d'une installation électrique ;
- la figure 8 représente un premier organigramme d'un procédé de maintenance d'une installation électrique selon un mode de réalisation de l'invention ;
- la figure 9 représente un second organigramme d'un procédé de maintenance d'une installation électrique selon un mode de réalisation de l'invention ;
- la figure 10 représente un organigramme d'un procédé de contrôle du vieillissement d'appareils électriques pouvant être associé avec un procédé de maintenance d'une installation électrique selon un mode de réalisation de l'invention ;
- la figure 11 représente un organigramme d'un procédé de contrôle de la sélectivité d'appareils électriques pouvant être associé avec un procédé de maintenance d'une installation électrique selon un mode de réalisation de l'invention.

### DESCRIPTION DETAILLEE DE MODES DE REALISATION PREFERES

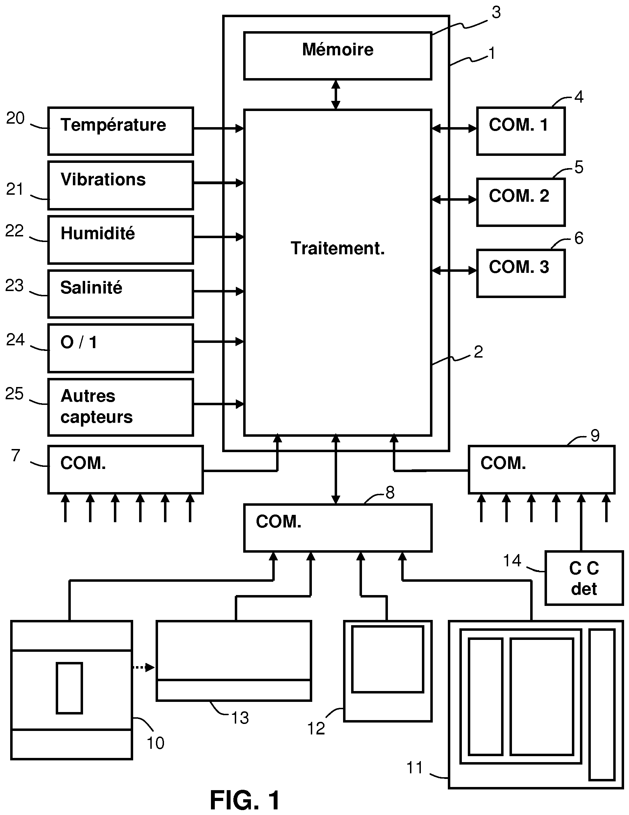

Le dispositif de maintenance d'une installation électrique selon un mode de réalisation de l'invention représenté sur la figure 1, comporte un module de traitement 1 représenté par un boîtier 1 comportant un circuit de traitement 2 effectuant des calculs et la gestion de communications ainsi que la réception et l'émission de données. Le module 1 comprend aussi un module 3 de stockage de caractéristiques de réglages d'appareils électriques, de schéma d'installation électrique, d'historique d'événements dans l'installation électrique et/ou des données de sélectivité et de calculs de vieillissement desdits d'appareils électriques. Le module 3 de stockage mémorise aussi des critères de criticité et des données utilisées dans un arbre de décision. Ces données peuvent être partagées, échangées ou dupliquées avec un superviseur ou d'autres modules de stockage. Pour communiquer avec d'autres dispositifs ou un superviseur, le module de traitement comporte au moins un circuit de communication 4 par voie filaire, et/ou un circuit de communication 5 sans fil, et/ou un circuit de communication 6 par réseau téléphonique cellulaire.

La visualisation sur un superviseur peut être représentée par un schéma filaire global ou partiel de l'installation montrant les états de chaque appareil ainsi que les références, les caractéristiques et les réglages. La signalisation peut être faite aussi sur des ordinateurs portables, des tablettes or des téléphones portables en liaisons sans fil ou par réseau de téléphonies cellulaire.

Un dispositif de contrôle selon un mode de réalisation de l'invention comporte un réseau de communication d'informations entre les appareils électriques et les moyens de traitement pour communiquer les informations. Le réseau de communication peut comporter les modules concentrateurs de communication 7, 8, 9 pour réduire le nombre d'entrées de communication du module de traitement. Les concentrateurs sont connectés à plusieurs appareils électriques 10, 11, 12, 13, 14 pour communiquer entre autres des informations de conditions de fonctionnement, de type et de références d'appareils au module de traitement 2 en regroupant les messages sur un canal de communication.

Les appareils électriques sont notamment des disjoncteurs 10, 11, avec par exemple, des déclencheurs électroniques ou des relais de protection. Les appareils peuvent être aussi des modules ou des relais 12 différentiels, de détection de fuite à la terre, des modules de mesure de puissance 13 associés de préférence à des appareils de coupures tels que des disjoncteurs ou des contacteurs. De même, des détecteurs de courts-circuits 14 peuvent donner des informations d'état d'une ligne électrique ou d'une charge pour éviter la fermeture d'un appareil ou localiser un défaut électrique de courts-circuits.

Le dispositif de maintenance d'une installation électrique de la figure 1 comporte des entrées de mesure destinées à être connectées à des capteurs de mesure de grandeurs physiques environnementales. Il communique et signale en local ou a distance des indications de maintenance de l'installation électrique. Ainsi, des capteurs de mesure de grandeurs physiques environnementales sont connectés au module de traitement 1.

Les capteurs de mesure de grandeurs physiques environnementales comprennent notamment :
- un capteur 20 de température situé de préférence dans un espace proche des appareils électriques concernés par un calcul de vieillissement,
- un capteur 21 d'amplitude et de fréquence de vibrations,
- un capteur 22 de taux d'humidité, et/ou
- un 23 capteur de taux de salinité.

Un capteur 24 d'entrée binaire tout ou rien peut aussi être connecté au module 1 pour le calcul de vieillissement. Dans ce cas, il peut par exemple compter le nombre de manoeuvres d'un appareil électrique. D'autres capteurs 25 peuvent aussi être connectés au module 1 pour aider à la maintenance de l'installation électrique.

Les capteurs 20 à 25 peuvent être des capteurs permanents ou des capteurs installés seulement lors des mesures. De plus, certaines données telles que le taux de salinité ou de poussière peuvent être déterminées préalablement et entrées directement par saisies.

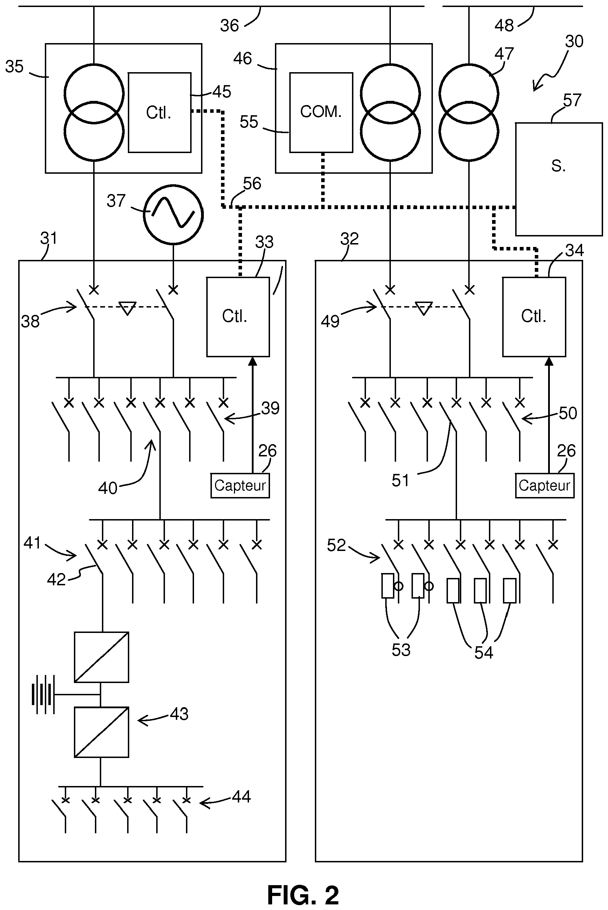

La figure 2 représente un schéma d'une installation électrique 30 comportant des moyens de maintenance selon un mode de réalisation de l'invention 1. Sur cette figure, l'installation comporte 2 armoires, cellules ou tableaux électriques 31, 32 comportant chacune un dispositif de maintenance de l'installation électrique respectivement 33 et 34.

L'armoire 31 est alimentée d'une part par un poste de transformation 35 connecté en amont à un réseau électrique moyenne tension 36 et d'autre part par un générateur autonome 37. Ces deux alimentations basses tensions arrivent sur un inverseur de source 38 composé de deux disjoncteurs télécommandés et verrouillés mécaniquement. En aval de l'inverseur, l'alimentation est fournie à un premier groupe 39 de disjoncteurs. Puis, un disjoncteur 40 du groupe 39 alimente un second groupe 41. Un disjoncteur 42 du second groupe alimente en aval un dispositif de conversion et de stockage d'énergie électrique 43, puis un troisième groupe de 44 de disjoncteurs. Le poste de transformation 35 peut comporter également des disjoncteurs ou des sectionneurs en amont sur la moyenne tension et sur le coté basse tension. Dans chaque armoire, des capteurs 26 de mesure de grandeurs physiques environnementales peuvent être communs pour l'aide à la maintenance de l'installation électrique. La maintenance de l'installation électrique est centralisée dans un dispositif 33 pour l'armoire 31 ou remontée dans un superviseur. Chaque armoire est alors une zone climatique de calcul du vieillissement des appareils électriques qui y sont installés. Chaque appareil électrique comportant un dispositif de communication envoie des informations de conditions de fonctionnement au dispositif de calcul de 33 qui enregistre tous les évènements qui surviennent dans cette partie de l'installation. Pour les autres appareils un calcul de leurs états peut être aussi réalisé en fonction de valeurs de conditions climatiques, de leur mesure, et de données préalablement mises en mémoire. Le dispositif 33 peut aussi enregistrer des données représentatives d'un calcul de sélectivité.

L'armoire 32 est alimentée d'une part par un poste de transformation 46 connecté en amont à un réseau électrique moyenne tension 36 et d'autre part par un transformateur 47 à un second réseau électrique moyenne tension 48. En aval du poste 46 et du transformateur 47, deux alimentations basses tensions arrivent sur un inverseur de source 49 composés de deux disjoncteurs télécommandés et verrouillés mécaniquement. En aval de l'inverseur, l'alimentation est fournie à un premier groupe 50 de disjoncteurs. Puis, un disjoncteur 51 du groupe 50 alimente un second groupe 52 de disjoncteurs. Les appareils comportant un dispositif de communication envoient des données de conditions de fonctionnement au dispositif 34. Des détecteurs de fuite à la terre ou des de défaut d'isolement 53 sont disposés sur des départs pour localiser des lignes en défauts. Des détecteurs de courts-circuits 54 disposés sur des départs permettent de localiser des défauts de ligne ou de charge. Les informations fournies par les détecteurs 53 et 54 sont définies comme des conditions de criticité élevée dans un arbre de décision et sont destinées à bloquer une remise en service de la partie de l'installation concernée. Eventuellement les détecteurs 54 peuvent de fournir aussi des informations de contraintes pour le calcul de vieillissement d'appareils électriques.

Un dispositif de communication 55 disposé dans le poste de transformation 46 peut aussi envoyer au dispositif de contrôle 34 des données servant au calcul de la sélectivité de l'installation.

Les dispositifs de maintenance de l'installation électrique sont connectés entre eux par un réseau de communication 56 et à un superviseur 57.

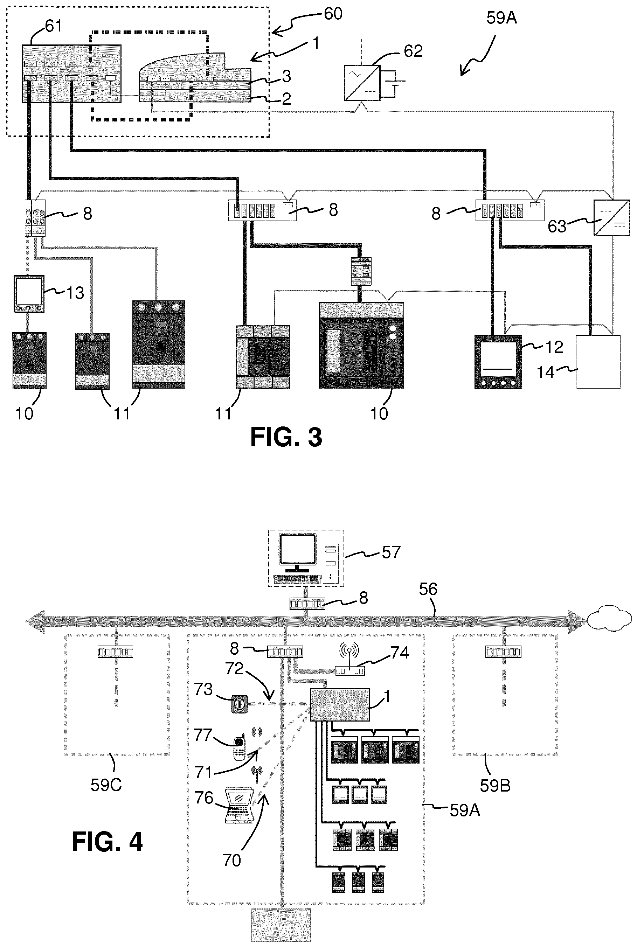

La figure 3 montre un autre schéma d'une partie d'installation 59 avec un dispositif de maintenance de l'installation électrique ayant dans un boitier 60 de traitement comprenant un module de traitement 1 et un module 61 de gestion des circuits de communication et des entrées-sorties de divers capteurs. Le circuit 61 est connecté à des concentrateurs de communication 8 recevant des informations depuis des appareils électriques 10 à 14. Les concentrateurs et les circuits de communication des appareils sont, par exemple, alimentés par les circuits d'alimentation comprenant des convertisseurs 62 et 64 ainsi que des lignes 64 et 65.

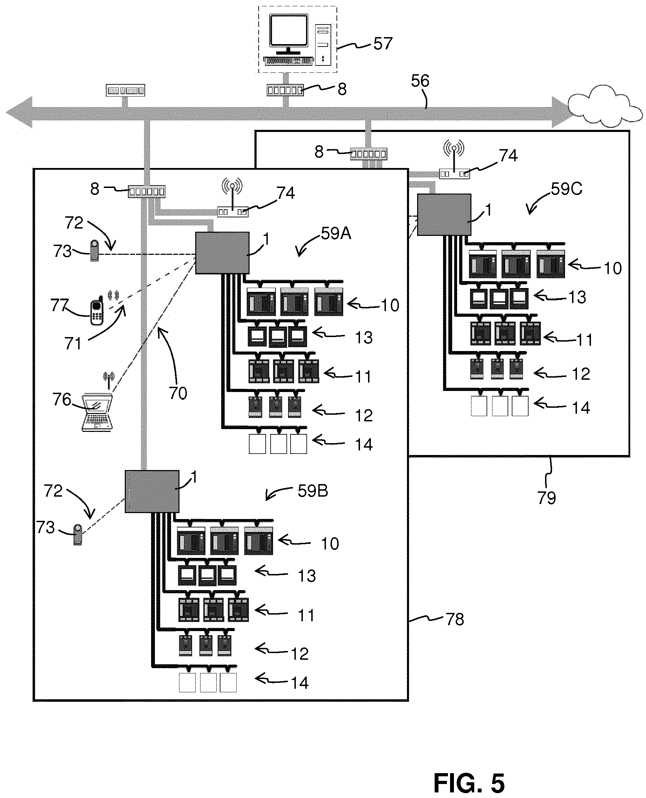

Les figures 4 et 5 représentent des installations selon des variantes de modes de réalisation de l'invention. Sur la figure 4, des parties d'installation 59A, 59B, 59C sont connectées à un réseau de communication 56 connecté à un superviseur 57. Ainsi, la maintenance de l'installation électrique est globale est peut être surveillée par un opérateur central ou distant. Pour assurer une sécurité et une robustesse de la surveillance des d'appareils électriques et la remontée efficace des évènements, le calcul peut être fait dans chaque dispositif de maintenance de l'installation électrique. De plus, les données de schéma, de réglage et de contrôle d'état de constitution d'historique d'événements sont de préférence échangées, comparées et consolidées dans chaque module de mémorisation des dispositifs de contrôle.

La partie d'installation 59A comporte une liaison de communication sans fil 70, une liaison de communication de téléphone cellulaire 71, et une liaison de communication radio 72 pour communiquer avec le module 60 de traitement de la maintenance de l'installation électrique. La liaison 72 est par exemple utilisée par un boitier 73 de commande d'ouverture ou de fermeture d'un appareil électrique tel qu'un disjoncteur télécommandé, un contacteur, ou un disjoncteur contacteur. Les liaisons 70 et 71 sont par exemple utilisées par un opérateur local pour être informé sur l'état de l'installation, les données de réglage et/ou les données de l'historique des évènements et pour modifier lesdites données ou commander les appareils à distance. Un module de communication sans fil 74 est connecté à un concentrateur 8 pour communiquer par exemple avec le superviseur ou avec d'autres parties de l'installation. Ainsi, la signalisation de l'état des d'appareils électriques ou de l'installation électrique peut être faite aussi sur des ordinateurs portables 76, des tablettes en liaisons sans fil 70 ou sur des téléphones portables 77 ou tablette par réseau de téléphonie cellulaire 71.

Sur la figure 5, des parties d'installation 59A et 59B sont par exemple dans un même local. Ainsi, certaines liaisons 70, 71 et modules 74 peuvent êtres mutualisés dans le même local 78. Les liaisons 72 avec les boitiers de télécommande sont associées à chaque module de traitement 1. Dans un autre local 79, une autre partie d'une installation 59C est connectée au superviseur et aux parties 59A, 59B à travers le réseau de communication 56.

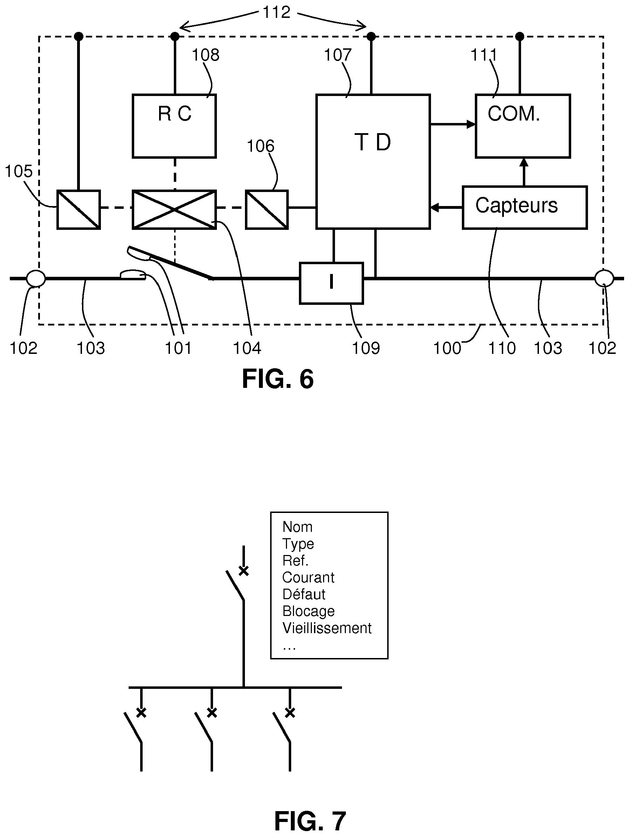

La figure 6 montre un schéma d'un appareil électrique tel qu'un disjoncteur 100 destiné à être utilisé avec un dispositif maintenance de l'installation électrique selon un mode de réalisation de l'invention. Le disjoncteur comporte des contacts de puissance 101 reliés à des bornes 102 de raccordement par des conducteurs de puissance 103. Les contacts 101 sont actionnés par un mécanisme 104 pouvant être commandé manuellement ou par les dispositifs de commande. Dans le disjoncteur de la figure 6 le mécanisme 104 est commandé par un actionneur 105 tel qu'une bobine à maximum de tension et/ou à manque de tension, par un relais de déclenchement 106 associé à un déclencheur 107, ou par un dispositif de télécommande 108 capable d'ouvrir ou de fermer les contacts 101. Le déclencheur électronique 107 reçoit des signaux représentatifs de courants circulant dans les conducteurs 103 et mesurés par les capteurs de courants 109. D'autres capteurs 110 sont connectés au déclencheur 107 pour fournir des informations telles que la température locale. Le disjoncteur comprend aussi un module de communication 111 connecté au déclencheur et/ou à des capteurs pour fournir au module 1 des informations de maintenance de l'installation électrique. Des bornes 112 permettent le raccordement de certains éléments du disjoncteur.

La figure 7 représente un schéma de présentation des données d'appareils électriques montrant des informations de maintenance de l'installation électrique ainsi qu'un arbre de décision. Ce type de schéma peut apparaitre sur des outils de contrôle et de diagnostic 57, 76, 77.

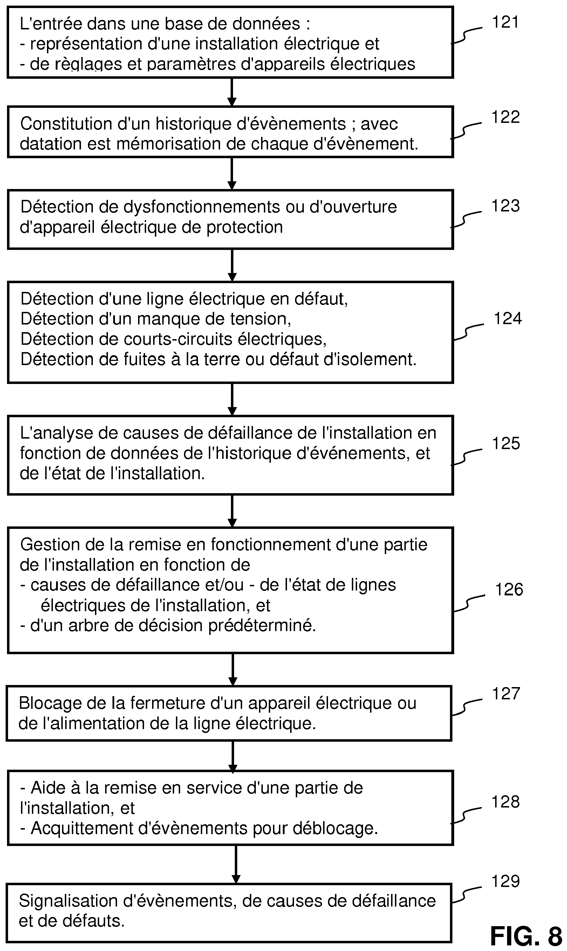

La figure 8 représente un premier organigramme d'un procédé de maintenance d'une installation électrique comportant au moins un appareil selon un mode de réalisation de l'invention. Dans une étape 121, il y a l'entrée dans une base de données d'informations représentatives d'une installation électrique à contrôler, et la mémorisation de données représentatives de réglages et de paramètres d'appareils électriques. Puis, une étape 122 réalise la datation et la mémorisation, dans une base de données, d'informations représentatives d'événements arrivant dans ladite installation électrique à contrôler de manière à constituer un historique d'évènements. Une étape 123 effectue la détection de perturbations de dysfonctionnements ou d'ouverture d'au moins un appareil électrique de protection dans l'installation électrique. Une étape 124 effectue la détection de défaillances supplémentaires tels que :
- la détection d'une ligne électrique en défaut,
- la détection d'un manque de tension dans une partie d'une installation électrique,
- la détection de courts-circuits électriques dans une ligne électrique, et/ou
- la détection de fuite à la terre ou de défaut d'isolement.

Une étape 125 effectue l'analyse de causes de défaillance de l'installation électrique en fonctions de données de l'historique d'événements et de l'état de l'installation. Puis une étape 126 effectue la gestion de la remise en fonctionnement d'une partie de l'installation hors service en fonction des causes de défaillance et/ou de l'état de lignes électriques de l'installation, et d'un arbre de décision prédéterminé. L'arbre de décision effectue des suites de tests successifs pour déterminer un niveau de criticité des défaillances et évaluer le risque de remettre en fonctionnement l'installation. Par exemple une mise à la terre ou un court circuit persistant sont considérés comme des défaillances de niveau de criticité élevé et ne permettent pas une remise en fonctionnement automatique de l'installation.

Une étape 127 effectue le blocage de la fermeture d'un appareil électrique ou de l'alimentation de ladite ligne électrique tant qu'un court-circuit est détecté. Ainsi, lorsqu'un court-circuit électrique dans une ligne est détecté à l'étape 124, l'étape 127 peut bloquer la réalimentation de ladite ligne tant que court circuit persiste. La signalisation et/ou la communication dudit blocage d'alimentation de ladite ligne est effectuée à une étape 129.

Lorsqu'un manque de tension est détecté à l'étape 124, l'étape 126 permet de déterminer l'origine dudit manque de tension de tension en fonction d'événements enregistrés dans l'historique d'évènements.

L'analyse des causes de défaillance à l'étape 125 comporte la sélection de défaillances ayant pour origine des défauts électriques et de défaillances n'ayant pas origine des défauts électrique.

Une étape 128 effectue une aide à la gestion de la remise en service de l'installation ou d'une partie de l'installation cette étape réalise notamment :
- la signalisation d'évènements,
- l'acquittement d'événements ayant un niveau de criticité élevé, et
- l'autorisation de l'alimentation d'une ligne électrique après l'acquittement d'événements ayant un niveau de criticité élevé.

Lorsque la défaillance concerne un appareil électrique, le procédé comprend notamment :
- une étape 125 de détection des causes d'ouverture d'un appareil électrique de coupure en fonction de la communication de son état, de commandes locales ou distantes, de conditions de fonctionnement, et/ou d'un calcul de vieillissement,
- une étape 127 de blocage de la re-fermeture manuelle ou automatique dudit appareil en défaut,
- une étape 129 de signalisation de causes critiques de défaut de l'installation, et
- une étape 128 d'acquittement d'évènements signalant au moins un défaut de l'appareil.

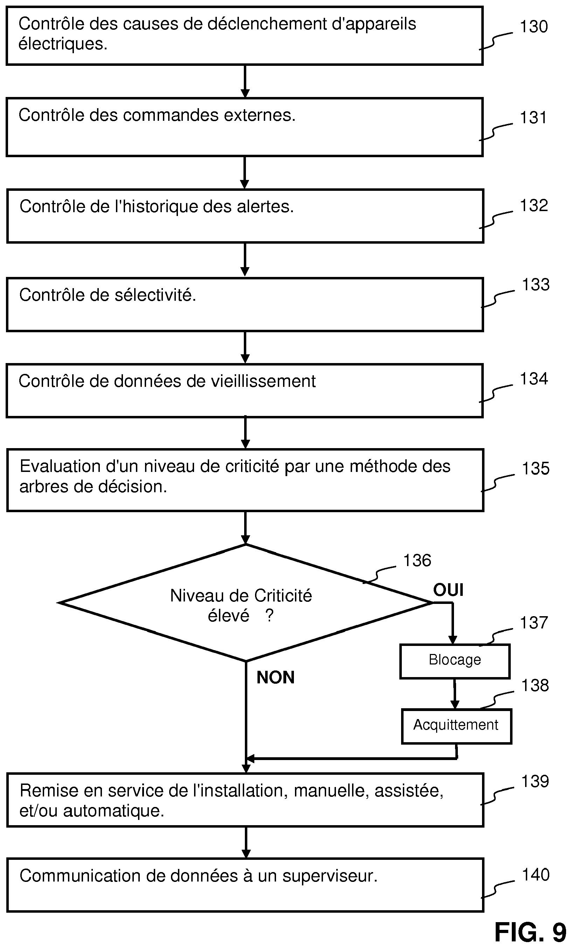

La figure 9 représente un second organigramme d'un procédé de maintenance d'une installation électrique selon un mode de réalisation de l'invention comprenant des étapes d'un arbre de décision.

Le contrôle selon un arbre de décision comprenant notamment ;
- une étape 130 de contrôle des causes de déclenchement d'un appareil électriques
- une étape 131 de contrôle des commandes externes,
- une étape 132 de contrôle de l'historique des alertes,
- une étape 133 de contrôle de sélectivité, et/ou
- une étape 134 de contrôle de données de vieillissement.
Ensuite une étape 135 évalue un niveau de criticité par la méthode des arbres de décision. Une étape 136 contrôle le niveau de criticité. Si le niveau de criticité est élevé une étape 137 bloque la fermeture d'un appareil électrique ou l'alimentation d'une partie de l'installation concernée. Puis une étape 138 permet l'acquittement des défauts critiques avant la re-fermeture locale ou à distance de l'appareil électrique. Ainsi, une étape 139 permet la remise en service de l'installation de manière manuelle, assistée ou automatique.

Cette étape 139 peut comporter aussi la commande à distance de fermeture d'appareil électrique ou d'alimentation de ligne électrique. Une étape 140 assure la communication de données à un superviseur. Ces évènements feront aussi partie de l'historique enregistré en mémoire.

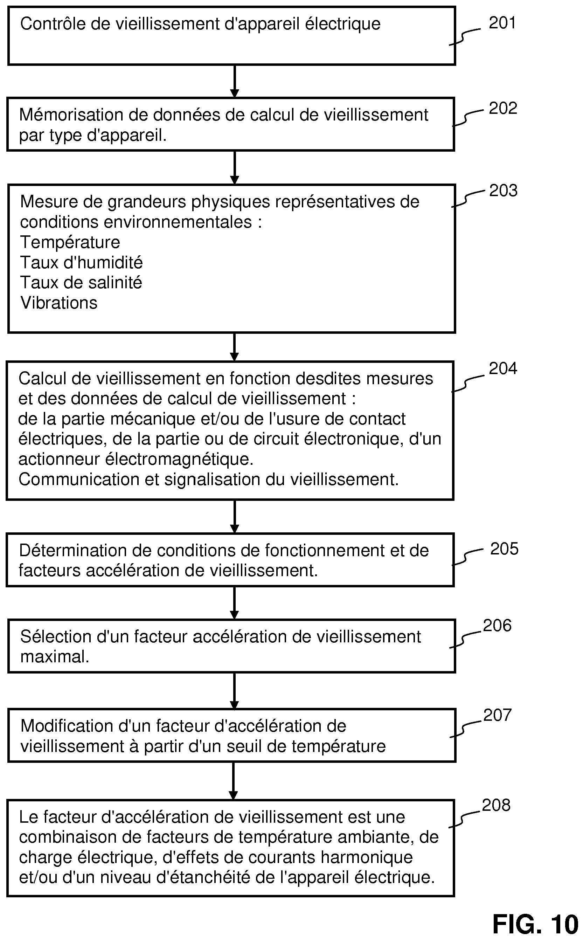

La figure 10 représente un organigramme d'un procédé de contrôle du vieillissement d'appareils électriques pouvant être associé avec un procédé de maintenance d'une installation électrique selon un mode de réalisation de l'invention. Cet organigramme correspond notamment à des fonctions réalisées à l'étape 134 représentée sur la figure 9.

L'étape 201 initialise le contrôle du vieillissement des appareils électriques. Elle mémorise notamment les caractéristiques de chaque type ou référence d'appareils électriques pouvant être utilisés dans l'installation. L'étape 202 effectue la mémorisation de données de calcul de vieillissement par type d'appareil. Le schéma est entré sous forme unifilaire en définissant les points de connexion en amont et en aval ainsi que les références de chaque appareil et des réglages. Le schéma peut être entré par des outils graphique ou importé depuis d'autres logiciels.

Une étape 203 effectue la mesure et l'enregistrement de grandeurs physiques représentatives de conditions environnementales. L'étape 203 comprend notamment :
- la mesure et la mémorisation de température par un capteur proche desdits appareils électriques,
- la mesure et la mémorisation de taux d'humidité,
- la mesure et la mémorisation de taux de salinité, et/ou
- la mesure et la mémorisation d'amplitude et de fréquence de vibrations.

Une étape 204 effectue le calcul de vieillissement en fonction desdites mesures et des données de calcul de vieillissement mémorisées. Dans cette étape le calcul de vieillissement comprend :
- le calcul de vieillissement de la partie mécanique et/ou de l'usure de contact électriques dudit appareil,
- le calcul de vieillissement de la partie électronique dudit appareil, et/ou
- le calcul de vieillissement d'un actionneur électromagnétique dudit appareil électrique.
A la fin du calcul il y a la communication et/ou la signalisation d'informations représentatives de résultats du calcul de vieillissement des appareils électriques.

Une étape 205 détermine des conditions de fonctionnement notamment en effectuant :
- le comptage de manoeuvres d'un appareil électrique,
- la mesure de conditions de manoeuvres de l'appareil électrique, et
- l'enregistrement de données représentatives de manoeuvres associées à des valeurs de courant coupé.

L'étape 205 effectue aussi la détermination ou le calcul de facteurs d'accélération de vieillissement. Une étape 206 sélectionne un facteur accélération de vieillissement maximal parmi plusieurs facteurs accélération de vieillissement. L'étape 206 permet de tenir compte d'une certaine indépendance des facteurs d'accélération du vieillissement. Il est aussi possible de pondérer plusieurs facteurs d'accélération en un facteur commun.

A une étape 207, le procédé modifie une valeur du facteur d'accélération de vieillissement dû à la température à partir d'un seuil de température. Par exemple, à partir de 85°C un circuit électronique peut avoir un facteur d'accélération de vieillissement beaucoup plus élevé.

Une étape 208 attribue au facteur d'accélération de vieillissement dû à la température une combinaison de facteurs d'accélération de vieillissement tels que la température ambiante, le type de charge électrique, les effets de courants harmoniques et/ou l'indice de protection (IP) dudit appareil électrique.

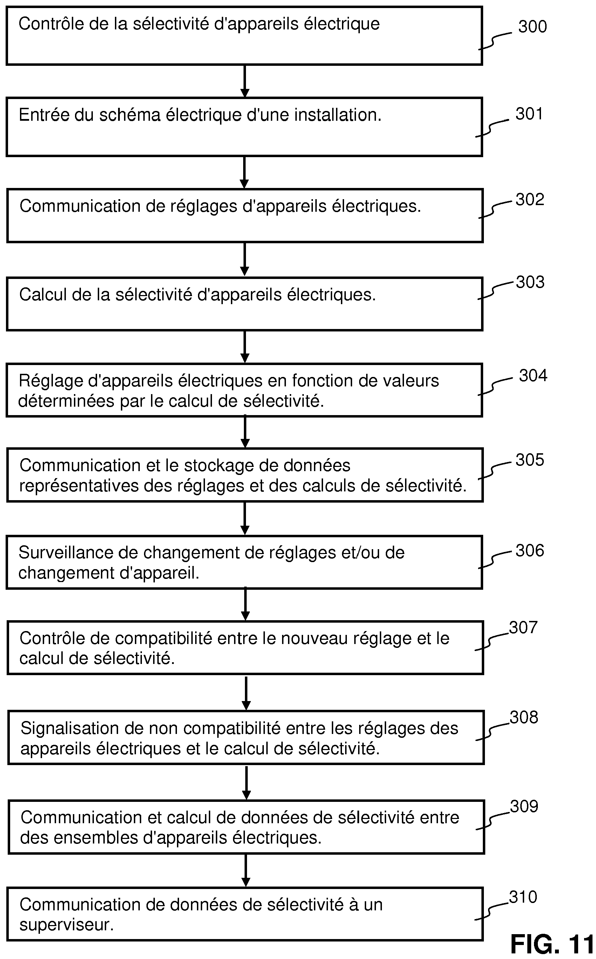

La figure 11 représente un organigramme d'un procédé de contrôle de la sélectivité d'appareils électriques pouvant être associé avec un procédé de maintenance d'une installation électrique selon un mode de réalisation de l'invention. Cet organigramme correspond notamment à des fonctions réalisées à l'étape 133 représentée sur la figure 9.

L'étape 300 initialise le contrôle de la sélectivité des appareils électriques. Elle mémorise notamment les caractéristiques de chaque type ou référence d'appareils électriques pouvant être utilisés dans l'installation. L'étape 301 permet l'entrée du schéma de l'installation électrique. Le schéma est entré sous forme unifilaire en définissant les points de connexion en amont et en aval ainsi que les références de chaque appareil est les réglages au moins pour les appareils sans dispositifs de communication. Le schéma peut être entré par des outils graphique ou importé depuis d'autres logiciels.

Ensuite une étape 302 réalise la communication de réglages d'appareils électriques entre au moins un appareil électrique et un concentrateur d'information ou un dispositif de traitement de la sélectivité. Une étape 303 effectue le calcul de la sélectivité d'appareils électriques en fonction desdits réglages d'appareils électriques. Le calcul de la sélectivité prend en compte des données de schéma électrique avec les connexions des appareils, les données de réglage desdits appareils entrées automatiquement par communication et éventuellement entrées manuellement pour des petits appareils sans communication. Une étape 304 permet le réglage d'appareils électriques en fonction de valeurs de réglages déterminées par le calcul de sélectivité. Cette étape 304 peut servir à un paramétrage initial ou à des réglages suivants. Ainsi ces réglages suivants peuvent être effectués manuellement, par téléréglage, de manière automatique par chargement de valeur à travers les dispositifs de communication, ou de manière semi automatique avec des réglages manuels, des téléréglages, et des réglages automatiques. Les parties automatiques des réglages sont de préférence soumises à autorisation et/ou acquittement. Une étape 305 réalise le stockage et la communication de données représentatives des nouveaux réglages et des données de sélectivité. Une étape 306 opère la surveillance de changement de réglages et/ou de changement d'appareil. Puis une étape 307 contrôle la compatibilité entre des nouveaux réglages après changement et le calcul de sélectivité.

En cas de non compatibilité, une étape 308 lance la signalisation de non compatibilité entre des réglages des appareils électriques et le calcul de sélectivité. La signalisation peut être réalisée en local, transmise à l'ensemble des modules de contrôle de la sélectivité et/ou à un superviseur.

A une étape 309, les données de sélectivité sont communiquées et calculées entre des ensembles d'appareils électriques. A une étape 310, lesdites données de sélectivité sont communiquées à un superviseur pour une vision globale de la sélectivité des appareils de l'installation. Le déclenchement du calcul de la sélectivité peut être déclenché à chaque changement d'appareil électrique ou à chaque changement de réglage d'au moins un appareil électrique.

Dans les installations décrites ci-dessus les liaisons entre les appareils sont décrites avec un réseau filaire et des concentrateurs. Ces liaisons filaires sont de préférence avec le standard de communication industriel "MODBUS". Cependant, d'autres standards peuvent être utilisés. Les liaisons peuvent aussi être des liaisons sans fils de types bien connus sous les noms de "WI-FI" ou "ZigBee"

## Revendications

1. Procédé de maintenance d'une installation électrique comportant au moins un appareil électrique, des moyens de traitement (1, 33, 34), et des moyens (7, 8, 9) de communication destinés à être connectés audit appareil électrique, dans lequel les moyens de traitement mettent en oeuvre les étapes suivantes:
- l'entrée (121) dans une base de données d'informations représentatives d'une installation électrique à contrôler,
- la mémorisation (121) de données représentatives de réglages et de paramètres d'appareils électriques,
- la mémorisation (122) dans une base de données d'informations représentatives d'évènements arrivant dans ladite installation électrique à contrôler de manière à constituer un historique d'évènements,
- la détection (123) de perturbations de dysfonctionnements ou d'ouverture d'au moins un appareil électrique de protection dans l'installation électrique,
- l'analyse (125) de causes de défaillance de l'installation électrique en fonctions de données de l'historique d'évènements et de l'état de l'installation,
- la gestion (126) de la remise en fonctionnement d'une partie de l'installation hors service en fonction des causes de défaillance et/ou de l'état de lignes électriques de l'installation, et d'un arbre de décision prédéterminé,
ladite gestion de la remise en fonctionnement comportant :
- la signalisation (129,140) d'événements,
- le blocage (127, 137) de la fermeture d'un appareil électrique de l'installation,
- l'acquittement (128, 138) d'événements ayant un niveau de criticité élevé,
- l'autorisation (128, 139) d'alimentation d'une ligne électrique après l'acquittement d'évènements ayant un niveau de criticité élevé.

2. Procédé de maintenance selon la revendication 1 **caractérisé en ce qu'**il comporte :
- La détection (124) d'un manque de tension dans une partie d'une installation électrique,
- la détermination (125) de l'origine dudit manque de tension de tension en fonction d'événements enregistrés dans l'historique d'événements.

3. Procédé de maintenance selon l'une des revendications 1 ou 2 **caractérisé en ce qu'**il comporte :
- la détection (124) de courts-circuits électriques dans une ligne électrique,
- le blocage (127, 137) de la fermeture d'un appareil électrique ou de l'alimentation de ladite ligne électrique tant qu'un court-circuit est détecté,
- la signalisation (129) et/ou la communication (140) dudit blocage d'alimentation de ladite ligne.

4. Procédé de maintenance selon l'une quelconque des revendications 1 à 3 **caractérisé en ce qu'**il comporte :
- la détection (123, 125) des causes d'ouverture d'un appareil électrique de coupure en fonction de la communication de son état, de commandes locales ou distantes, de conditions de fonctionnement, et/ou d'un calcul de vieillissement,
- le blocage (127, 137) de la re-fermeture manuelle ou automatique dudit appareil en défaut,
- la signalisation (129, 140) de causes critiques de défaut de l'installation, et
- l'acquittement (128, 139) d'évènement signalant au moins un défaut de l'appareil.

5. Procédé de maintenance selon l'une quelconque des revendications 1 à 4 **caractérisé en ce qu'**il comporte la sélection (125) de défaillances ayant pour origine des défauts électriques et de défaillances n'ayant pas origine des défauts électrique.

6. Procédé de maintenance selon l'une quelconque des revendications 1 à 5 **caractérisé en ce qu'**il comporte l'évaluation (135, 126) d'un niveau de criticité par un arbre de décision comprenant :
- le contrôle (130) des causes de déclenchement d'un appareil électriques
- le contrôle (131) des commandes externes,
- le contrôle (132) de l'historique des alertes,
- le contrôle (133) de sélectivité, et/ou
- le contrôle (134) de données de vieillissement.

7. Procédé de maintenance selon l'une quelconque des revendications 1 à 6 **caractérisé en ce qu'**il comporte la commande (128, 139) à distance de fermeture d'appareil électrique ou d'alimentation de ligne électrique,

8. Dispositif de maintenance d'une installation électrique comportant au moins un appareil électrique, des moyens de traitement (1, 33, 34), et des moyens (7, 8, 9) de communication destinés à être connectés audit appareil électrique **caractérisé en ce que** les moyens de traitement comportent des moyens mettant en oeuvre un procédé selon l'une quelconque des revendications 1 à 7.

9. Dispositif de maintenance selon la revendication 8 **caractérisé en ce que** lesdits moyens de traitement comportent :
- des moyens (3) de stockage de données représentatives d'une installation électrique à contrôler,
- des moyens (3) de stockage de données représentatives de réglages et de paramètres d'appareils électriques,
- des moyens (3) de stockage d'informations représentatives d'évènements arrivant dans ladite installation électrique à contrôler de manière à constituer un historique d'évènements, et
- des moyens (4-9, 61) de communication.

10. Dispositif de maintenance selon l'une des revendications 8 ou 9 **caractérisé en ce qu'**il comporte au moins un détecteur de courts circuits (14, 54) connecté à au moins une ligne de l'installation électrique à contrôler pour fournir aux moyens de traitement des signaux représentatif de la présence d'un court-circuit.

11. Dispositif de maintenance selon l'une quelconque des revendications 8 à 10 **caractérisé en ce qu'**il comporte au moins un détecteur (12, 53) de fuite de courant ou un contrôleur d'isolement (12, 53) disposé ou connecté à au moins une ligne de l'installation électrique à contrôler pour fournir au moyens de traitement des signaux représentatifs d'une fuite de courant à la terre ou d'un défaut d'isolement.

12. Dispositif de maintenance selon l'une quelconque des revendications 8 à 11 **caractérisé en ce qu'**il comporte des moyens de réception (1, 108) de commande à distance d'au moins un appareil électrique.

13. Installation électrique comportant des moyens de maintenance d'au moins un appareil électrique comportant des moyens de traitement (1, 33, 34, 45, 55) et des moyens (3, 8, 56, 57) de communication destinés à être connectés à un appareil électrique (10-14, 38, 38, 41, 49, 50, 52) **caractérisé en ce que** les moyens de traitement comportent des moyens mettant en oeuvre un procédé selon l'une quelconque des revendications 1 à 7.

14. Installation électrique selon la revendication 13 comportant des appareils électriques (10-14, 38, 38, 41, 49, 50, 52) **caractérisé en ce qu'**elle comporte au moins un dispositif (1, 33, 34, 45, 55) selon l'une quelconque des revendications 8 à 12 connecté par des moyens de communication (3, 8, 56, 57) auxdits appareils électriques pour recevoir des données représentatives d'évènements.

## Patentansprüche

1. Verfahren zur Wartung einer elektrischen Anlage, umfassend mindestens ein elektrisches Gerät, Bearbeitungsmittel (1, 33, 34) und Kommunikationsmittel (7, 8, 9), die dazu bestimmt sind, an das elektrische Gerät angeschlossen zu werden, wobei die Bearbeitungsmittel die folgenden Schritte einsetzen:
- Eingabe (121) von Informationsdaten, die für eine zu kontrollierende elektrische Anlage repräsentativ sind, in eine Datenbasis,
- Speicherung (121) von Daten, die für Einstellungen und Parameter von elektrischen Geräten repräsentativ sind,
- in einer Datenbasis Speicherung (122) von Informationsdaten, die für Ereignisse repräsentativ sind, die in der zu kontrollierenden elektrischen Anlage vorkommen, um eine Historie von Ereignissen zu erstellen,
- Erfassung (123) von Störungen im Zusammenhang mit Fehlfunktionen oder einer Öffnung mindestens eines elektrischen Schutzgeräts in der elektrischen Anlage,
- Analyse (125) von Ausfallursachen der elektrischen Anlage in Abhängigkeit von Daten der Ereignishistorie und des Zustands der Anlage,
- Steuerung (126) der Wiederinbetriebsetzung eines Teils der Anlage außer Betrieb in Abhängigkeit von den Ausfallursachen und/oder dem Zustand von elektrischen Leitungen der Anlage und einem vorbestimmten Entscheidungsbaum,
wobei die Steuerung der Wiederinbetriebsetzung umfasst:
- die Anzeige (129, 140) von Ereignissen,
- das Blockieren (127, 137) des Schließens eines elektrischen Geräts der Anlage,
- das Quittieren (128, 138) von Ereignissen mit hoher Sicherheitskritikalität,
- das Gestatten (128, 139) einer Versorgung einer elektrischen Leitung nach dem Quittieren von Ereignissen mit hoher Sicherheitskritikalität.

2. Wartungsverfahren nach Anspruch 1, **dadurch gekennzeichnet, dass** es umfasst:
- die Erfassung (124) eines Spannungsmangels in einem Teil einer elektrischen Anlage,
- die Bestimmung (125) der Ursache des Spannungsmangels in Abhängigkeit von in der Ereignishistorie registrierten Ereignissen.

3. Wartungsverfahren nach einem der Ansprüche 1 oder 2, **dadurch gekennzeichnet, dass** es umfasst:
- die Erfassung (124) von elektrischen Kurzschlüssen in einer elektrischen Leitung,
- das Blockieren (127, 137) des Schließens eines elektrischen Geräts oder der Versorgung der elektrischen Leitung, solange ein Kurzschluss erfasst wird,
- die Anzeige (129) und/oder die Kommunikation (140) des Blockierens einer Versorgung der Leitung.

4. Wartungsverfahren nach einem der Ansprüche 1 bis 3, **dadurch gekennzeichnet, dass** es umfasst:
- die Erfassung (123, 125) der Ursachen für das Öffnen eines elektrischen Schaltgeräts in Abhängigkeit von der Kommunikation seines Zustands, von lokalen Steuerungen oder Fernsteuerungen, Funktionsbedingungen und/oder einer Alterungsberechnung,
- das Blockieren (127, 137) des manuellen oder automatischen Wiederschließens des fehlerhaften Geräts,
- die Anzeige (129, 140) von kritischen Fehlerursachen der Anlage, und
- das Quittieren (128, 139) eines Ereignisses, das mindestens einen Fehler des Geräts anzeigt.

5. Wartungsverfahren nach einem der Ansprüche 1 bis 4, **dadurch gekennzeichnet, dass** es die Auswahl (125) von Ausfällen, die als Ursache elektrische Fehler haben, oder von Ausfällen, die keine elektrischen Fehler als Ursache haben, umfasst.

6. Wartungsverfahren nach einem der Ansprüche 1 bis 5, **dadurch gekennzeichnet, dass** es die Bewertung (135, 126) einer Sicherheitskritikalität durch einen Entscheidungsbaum umfasst, umfassend:
- die Kontrolle (130) der Ursachen für das Auslösen eines elektrischen Geräts,
- die Kontrolle (131) der externen Steuerungen,
- die Kontrolle (132) der Historie der Alarmmeldungen,
- die Selektivitätskontrolle (133), und/oder
- die Kontrolle (134) von Alterungsdaten.

7. Wartungsverfahren nach einem der Ansprüche 1 bis 6, **dadurch gekennzeichnet, dass** es die Fernsteuerung (128, 139) eines Schließens eines elektrischen Geräts oder einer Versorgung einer elektrischen Leitung umfasst.

8. Vorrichtung zur Wartung einer elektrischen Anlage, umfassend mindestens ein elektrisches Gerät, Bearbeitungsmittel (1, 33, 34) und Kommunikationsmittel (7, 8, 9), die dazu bestimmt sind, an das elektrische Gerät angeschlossen zu werden, **dadurch gekennzeichnet, dass** die Bearbeitungsmittel Mittel umfassen, die ein Verfahren nach einem der Ansprüche 1 bis 7 einsetzen.

9. Wartungsvorrichtung nach Anspruch 8, **dadurch gekennzeichnet, dass** die Bearbeitungsmittel umfassen:
- Mittel (3) zur Speicherung von Daten, die für eine zu kontrollierende elektrische Anlage repräsentativ sind,
- Mittel (3) zur Speicherung von Daten, die für Einstellungen und Parameter von elektrischen Geräten repräsentativ sind,
- Mittel (3) zur Speicherung von Informationen, die für Ereignisse repräsentativ sind, die in der zu kontrollierenden elektrischen Anlage vorkommen, um eine Historie von Ereignissen zu erstellen, und
- Kommunikationsmittel (4-9, 61).

10. Wartungsvorrichtung nach einem der Ansprüche 8 oder 9, **dadurch gekennzeichnet**, sie mindestens einen Kurzschlussdetektor (14, 54) umfassen, der an mindestens eine Leitung der zu kontrollierenden elektrischen Anlage angeschlossen ist, um an die Bearbeitungsmittel Signale zu liefern, die für das Vorliegen eines Kurzschlusses repräsentativ sind.

11. Wartungsvorrichtung nach einem der Ansprüche 8 bis 10, **dadurch gekennzeichnet, dass** es mindestens einen Verluststromdetektor (12, 53) oder einen Isolierungswächter (12, 53) umfasst, der an mindestens einer Leitung der zu kontrollierenden elektrischen Anlage angeordnet oder an diese angeschlossen ist, um an die Bearbeitungsmittel Signale zu liefern, die für einen Stromverlust gegen Erde oder einen Isolierungsfehler repräsentativ sind.

12. Wartungsvorrichtung nach einem der Ansprüche 8 bis 11, **dadurch gekennzeichnet, dass** sie Empfangsmittel (1, 108) einer Fernsteuerung mindestens eines elektrischen Geräts umfasst.

13. Elektrische Anlage, umfassend Mittel zur Wartung mindestens eines elektrischen Geräts, umfassend Bearbeitungsmittel (1, 33, 34, 45, 55) und Kommunikationsmittel (3, 8, 56, 57), die dazu bestimmt sind, an ein elektrisches Gerät (10-14, 38, 38, 41, 49, 50, 52) angeschlossen zu werden, **dadurch gekennzeichnet, dass** die Bearbeitungsmittel Mittel umfassen, die ein Verfahren nach einem der Ansprüche 1 bis 7 einsetzen.

14. Elektrische Anlage nach Anspruch 13, umfassend elektrische Geräte (10-14, 38, 38, 41, 49, 50, 52), **dadurch gekennzeichnet, dass** sie mindestens eine Vorrichtung (1, 33, 34, 45, 55) nach einem der Ansprüche 8 bis 12 umfasst, die durch Kommunikationsmittel (3, 8, 56, 57) an die elektrischen Geräte angeschlossen ist, um für Ereignisse repräsentative Daten zu empfangen.

## Claims

1. Method for maintaining an electrical installation including at least one electrical device, processing means (1, 33, 34) and communication means (7, 8, 9) intended to be connected to said electrical device, wherein the processing means implement the following steps:
- inputting (121), into a database, information representative of an electrical installation to be monitored,
- storing (121) data representative of settings and of parameters of electrical devices,
- storing (122), in a database, information representative of events occurring in said electrical installation to be monitored, so as to create an event log,
- detecting (123) disturbances, malfunctions or the opening of at least one electrical protection device in the electrical installation,
- analysing (125) causes of failure of the electrical installation on the basis of data from the event log and of the status of the installation,
- managing (126) the return to operation of a portion of the installation that is out of service on the basis of the causes of failure and/or of the status of electrical lines of the installation, and of a predetermined decision tree,
said management of the return to operation including:
- signalling (129, 140) events,
- blocking (127, 137) the closure of an electrical device of the installation,
- acknowledging (128, 138) events with a high level of criticality,
- authorizing (128, 139) the supply of power to an electrical line after acknowledging events with a high level of criticality.

2. Maintenance method according to Claim 1, **characterized in that** it includes:
- detecting (124) a lack of voltage in a portion of an electrical installation,
- determining (125) the origin of said lack of voltage on the basis of events recorded in the event log.

3. Maintenance method according to either of Claims 1 and 2, **characterized in that** it includes:
- detecting (124) electrical short circuits in an electrical line,
- blocking (127, 137) the closure of an electrical device or the supply of power to said electrical line as long as a short circuit is detected,
- signalling (129) and/or communicating (140) said blockage of the supply of power to said line.

4. Maintenance method according to any one of Claims 1 to 3, **characterized in that** it includes:
- detecting (123, 125) the causes of opening of an electrical switching device on the basis of the communication of its status, of local or remote commands, of operating conditions and/or of a calculation of ageing,
- blocking (127, 137) the manual or automatic reclosure of said faulty device,
- signalling (129, 140) critical fault causes of the installation, and
- acknowledging (128, 139) an event signalling at least one device fault.

5. Maintenance method according to any one of Claims 1 to 4, **characterized in that** it includes selecting (125) failures originating from electrical faults and failures not originating from electrical faults.

6. Maintenance method according to any one of Claims 1 to 5, **characterized in that** it includes evaluating (135, 126) a level of criticality using a decision tree comprising:
- monitoring (130) trip causes of an electrical device,
- monitoring (131) external commands,
- monitoring (132) the alert log,
- monitoring (133) selectivity, and/or
- monitoring (134) ageing data.

7. Maintenance method according to any one of Claims 1 to 6, **characterized in that** it includes remotely controlling (128, 139) the closure of an electrical device or the supply of power to an electrical line.

8. Device for maintaining an electrical installation including at least one electrical device, processing means (1, 33, 34) and communication means (7, 8, 9) intended to be connected to said electrical device, **characterized in that** the processing means include means implementing a method according to any one of Claims 1 to 7.

9. Maintenance device according to Claim 8, **characterized in that** said processing means include:
- means (3) for storing data representative of an electrical installation to be monitored,
- means (3) for storing data representative of settings and of parameters of electrical devices,
- means (3) for storing information representative of events occurring in said electrical installation to be monitored, so as to create an event log, and
- communication means (4-9, 61).

10. Maintenance device according to either of Claims 8 and 9, **characterized in that** it includes at least one short-circuit detector (14, 54) connected to at least one line of the electrical installation to be monitored in order to provide, to the processing means, signals representative of the presence of a short circuit.

11. Maintenance device according to any one of Claims 8 to 10, **characterized in that** it includes at least one leakage current detector (12, 53) or an isolation monitor (12, 53) positioned at or connected to at least one line of the electrical installation to be monitored in order to provide, to the processing means, signals representative of a ground leakage current or of an isolation fault.

12. Maintenance device according to any one of Claims 8 to 11, **characterized in that** it includes means (1, 108) for receiving remote commands from at least one electrical device.

13. Electrical installation including means for maintaining at least one electrical device including processing means (1, 33, 34, 45, 55) and communication means (3, 8, 56, 57) intended to be connected to an electrical device (10-14, 38, 38, 41, 49, 50, 52), **characterized in that** the processing means include means implementing a method according to any one of Claims 1 to 7.

14. Electrical installation according to Claim 13 including electrical devices (10-14, 38, 38, 41, 49, 50, 52), **characterized in that** it includes at least one device (1, 33, 34, 45, 55) according to any one of Claims 8 to 12 connected, via communication means (3, 8, 56, 57), to said electrical devices in order to receive data representative of events.
